# EUROPEAN PATENT APPLICATION

(11) **EP 4 428 557 A1**
(43) Date of publication of application: **11.09.2024**
(21) Application number: 23161143.5
(22) Date of filing: 10.03.2023
(51) Int. Cl.: G01R 33/36

(54) **RADIO FREQUENCY CABLE TRAP ASSEMBLY WITH INDICATION CIRCUIT**

(71) Applicant: Koninklijke Philips N.V., 5656 AG Eindhoven (NL)
(72) Inventor: FINDEKLEE, Christian, Eindhoven (NL); LEUSSLER, Christoph Günther, Eindhoven (NL); VERNICKEL, Peter, 5656AG Eindhoven (NL)
(74) Representative: Philips Intellectual Property & Standards

(57) **Abstract**

Disclosed herein is a radio frequency cable trap assembly (100) comprising a radio frequency cable trap circuit (102). The radio frequency cable trap is configured for suppressing an inducing of an alternating energy at a predefined magnetic resonance imaging operation frequency in a cable (200) for a magnetic resonance imaging coil (302, 310, 314). The assembly (100) further comprises an indication circuit (104) comprising an output unit (111) configured for outputting an indication signal upon a reaching of a predefined upper threshold by the suppressed energy. The indication circuit (104) is configured for determining the reaching of the predefined upper threshold using a portion of the suppressed energy transferred from the radio frequency cable trap circuit (102) to the indication circuit (104) via an energy transfer coupling between the radio frequency cable trap circuit (102) and the indication circuit (104).

## Description

### FIELD OF THE INVENTION

The invention relates to magnetic resonance imaging, in particular to a radio frequency trap for a cable of a magnetic resonance imaging coil.

### BACKGROUND OF THE INVENTION

Undesired currents, like common-mode currents, which may travel along a shield of cabling in a magnetic resonance system, may adversely affect radio frequency coil performance, e.g., by affecting coil decoupling and tuning. Furthermore, energy dissipated from the cabling may create heat that poses a risk of causing patient burns. To suppress such currents, radio frequency cable trap circuits may be used, which introduce a high impedance for common mode currents on a cable. There are several designs known for radio frequency cable trap circuits in magnetic resonance systems, e.g., tank circuits and bazooka baluns.

### SUMMARY OF THE INVENTION

The invention provides for a radio frequency cable trap assembly, a cable for a magnetic resonance imaging coil with such a radio frequency cable trap assembly, a magnetic resonance imaging coil with such a cable, and a magnetic resonance imaging system comprising such a magnetic resonance imaging coil.

In one aspect, the invention provides for a radio frequency cable trap assembly comprising a radio frequency cable trap circuit. The radio frequency cable trap is configured for suppressing an inducing of an alternating energy at a predefined magnetic resonance imaging operation frequency in a cable for a magnetic resonance imaging coil.

The assembly further comprises an indication circuit comprising an output unit configured for outputting an indication signal upon a reaching of a predefined upper threshold by the suppressed energy, i.e., the energy resulting from the suppression. For outputting the indication signal, the indication circuit uses a portion of the suppressed energy transferred from the radio frequency cable trap circuit to the indication circuit via an energy transfer coupling between the radio frequency cable trap circuit and the indication circuit.

The reaching of the predefined upper threshold by the suppressed energy may, e.g., be sensed and/or measured via a direct or indirect sensing and/or measuring. For example, the suppressed energy may be sensed and/or measured using a suitable sensor and/or any other physical quantity, which is indicative of the suppressed energy, e.g., a power, current, voltage, and/or temperature resulting from the suppressed energy, may be sensed and/or measured using a suitable sensor. The suppressed energy and/or the other physical quantity, e.g., power, current, voltage, and/or temperature resulting from the suppressed energy, may, e.g., be sensed and/or measured within the radio frequency cable trap circuit. For example, a physical quantity, which is indicative of the suppressed energy, e.g., a power, current, voltage, and/or temperature resulting from the suppressed energy due to the energy transferred from the radio frequency cable trap circuit to the indication circuit via an energy transfer coupling, may be sensed and/or measured within the indication circuit.

The indication signal indicates that the predefined upper threshold is reached by the suppressed energy. Depending on the sensing and/or measuring executed within the radio frequency cable trap assembly, the indication signal may be in addition indicative of other sensory values sensed and/or measured within the radio frequency cable trap assembly.

The portion of the suppressed energy transferred from the radio frequency cable trap circuit to the indication circuit may, e.g., be used for supplying the output unit with energy for outputting the indication signal. The portion of the suppressed energy transferred from the radio frequency cable trap circuit to the indication circuit may, e.g., be used for activating an outputting mode of the output unit. The portion of the suppressed energy transferred from the radio frequency cable trap circuit to the indication circuit may, e.g., be used for indicating the reaching of the predefined upper threshold.

The indication circuit may, e.g., be configured for determining the reaching of the predefined upper threshold. For example, the indication circuit is configured for determining the reaching of the predefined upper threshold using a portion of the suppressed energy transferred from the radio frequency cable trap circuit to the indication circuit via an energy transfer coupling between the radio frequency cable trap circuit and the indication circuit.

The indication signal may take different forms in different examples, e.g., the form of a visual, an acoustic and/or a wireless signal to warn an operator of a magnetic resonance system of the reaching of the predefined upper threshold by the suppressed energy. In other examples, the indication signal may be used to trigger other components of the magnetic resonance imaging system. In one example, the indication signal could automatically trigger a stopping of a magnetic resonance scan executed by the magnetic resonance imaging system.

Although described in context of a cable for a magnetic resonance imaging coil, the radio frequency cable trap assembly described herein may be used for any galvanic connection arranged or intended for being arranged within a B 1-field of a magnetic resonance imaging system.

Magnetic resonance imaging (MRI) is an imaging technology that is based on the principles of nuclear magnetic resonance, i.e., that atomic nuclei with non-zero spin have a magnetic moment. In medical magnetic resonance imaging, the atomic nuclei with non-zero spin is usually the nuclei of hydrogen atoms, which are present in the human or animal body. Radio frequency (RF) waves forming a B 1-excitation field, are directed at the nuclei in an external magnetic field, leading to an excitation of the protons and a subsequent relaxing process of the protons. Relaxation of the protons, results in radio frequency signals being emitted by the nuclei that may be detected and processed to form an image.

A typical magnetic resonance imaging system generally comprises a magnet, for example a superconducting electromagnet, that generates a strong static magnetic field, gradient coils that generate linear variations in the static magnetic field, radio frequency transmit coils that generate the B 1-excitation field, and radio frequency receive coils that detect the magnetic resonance radio frequency signal emitted by the relaxing nuclei. Typically, cables, like, e.g., coaxial cables, are used in magnetic resonance systems for the controlled transmission of radio frequency signals within the coils. Furthermore, coils in a magnetic resonance system, like radio frequency coils, are connected via cable transmission lines, e.g., coaxial cable transmission lines, to a computer unit controlling the magnetic resonance system and processing acquired magnetic resonance signals.

In a magnetic resonance imaging system, cables arranged within the system may couple to the radio frequency transmit field, i.e., B1 field in an unintended way and act like undesired antennas. This is referred to as the antenna effect. Wires and in general any elongated conductive object arranged within a B1 field may act like an antenna, capturing electromagnetic waves to extract energy from them. Antennas may produce standing-wave patterns of voltage and current, maximal when their length is one-half of the radio frequency wavelength. Such currents may cause a radio frequency induced heating of the antenna, e.g., a cable, resulting in a risk of causing thermal injuries of a patient in the vicinity of the heated antenna.

For example, a coaxial cable has an outer shield and an inner conductor that are separated from one another by a dielectric material. Both together form a radio frequency transmission line of defined and stable propagation properties, like velocity and characteristic impedance. Thereby, the outer shield may protect the inner conductor from picking up undesired frequencies. A magnetic resonance signal acquired by a radio frequency coil of the magnetic resonance system may, e.g., be transmitted on a coaxial cable in the differential mode on an inner conductor and an inner surface of an outer conductor.

However, sources external to the coaxial cable may induce unintended electrical currents in the outer shield and thus generate unintended signals that may, e.g., influence a signal-to-noise ratio of a radio frequency receive coil adversely. In case of high fields, an outer surface of the outer conductor of the coaxial cable may electromagnetically couple to radiated fields or a radio frequency transmit field, i.e., B1 field. This coupling may induce undesired currents in the common mode. Due to the skin effect, the inner and outer surfaces of the coaxial shield may effectively be separated at radio frequency. Nevertheless, common mode currents may cause issues by coupling to nearby dielectrics, e.g., a patient, and radio frequency coils. A residual coupling of common mode currents to the receive signal path may result in the cable itself acting like an undesired antenna. This may cause patient burns. Furthermore, the coil filling factor and power efficiency may be reduced. Furthermore, depending on cable routing, common mode currents have the potential to generate high local electric fields and may thereby cause surface burns on a patient's body.

For these reasons, radio frequency cable trap circuits are used with cables in magnetic resonance systems. The radio frequency cable trap circuit may have the beneficial effect of introducing a high impedance. This impedance may enable a suppression of an alternating energy, e.g., an alternating current, at the predefined magnetic resonance imaging operation frequency. For example, the impedance may be introduced for a common mode current on a cable. In magnetic resonance imaging systems, such an alternating energy, e.g., in form of common mode currents, may be induced via a body coil during transmission of radio frequency pulses. A common mode current refers to a portion of conductor currents not matched by opposite and equal magnitude currents. This is the portion of total current responsible for a feedline behaving like a single wire line. The current flowing in common mode may be decreased by a sufficiently high common mode impedance. Thus, increasing the common mode impedance may decreases, i.e., suppresses, the common mode current on a cable or any other galvanic connection, like, e.g., also a twinax or twisted pair connection.

The radio frequency cable trap circuit may, e.g., form a resonant structure with at least one electric and at least one magnetic energy storage which form a high impedance for a common mode on the cable. This may, e.g., be realized by forming a resonant structure from a part of the transmission line directly or by, e.g., mainly, inductive coupling between the resonant structure and the cable.

An MR-compatible cable trap circuit may be based on a resonant structure which stores both, electric and magnetic energy. Different methods may be used to build such a resonant trap structure. For example, a coil may be made from a transmission line such that a common mode feels an inductor. That inductor may, e.g., be connected to a parallel capacitor to form a parallel resonant circuit. That capacitor, however, does not need to be realized by a lumped component. The capacitive coupling between windings of the coil may, e.g., act as the electric energy storage. The coil may, e.g., also be formed by a separate structure, coupling, e.g., mainly inductively, to the cable. Also, a coaxial structure may, e.g., be used to form an inductively coupling structure instead of a coil. This may, e.g., directly use the cable as an inner part. The length may, e.g., be chosen to a quarter wave then to form a monopole resonator structure, which is referred to as bazooka balun.

The radio frequency cable trap assembly is designed without magnetic material to ensure magnetic resonance compatibility. Resonant structures are used, which form high impedances at the predefined magnetic resonance imaging operating frequency. For narrow-band pulses used by a magnetic resonance imaging system, high impedances at the predefined magnetic resonance imaging operating frequency may be sufficient. In special cases, also multiple nuclei may be used for imaging. Then, e.g., a multi-resonant radio frequency cable trap circuit resonant for a plurality of different magnetic resonance imaging operating frequencies or a plurality of radio frequency cable trap assemblies resonant for different magnetic resonance imaging operating frequencies may be used. Moreover, a multitenant structure can be realized which combines two or more modes.

Even in case a radio frequency cable trap circuit is used, errors and/or problems may occur. These errors and/or problems may, e.g., cause an insufficient suppression of the induced alternating energy by the radio frequency cable trap circuit. The predefined upper threshold may be defined such that a negative impact on a patient, e.g., due to a heating caused by the induced energy above a safe temperature, may be excluded or at least unlikely. Thus, when the suppressed energy reaches the upper predefined threshold, a resulting risk may be indicated by the indication signal output by the indication circuit. The predefined upper threshold may, e.g., be defined as a temperature threshold. When the respective temperature threshold is reached, it may be concluded that the suppression of the inducing of the alternating energy is insufficient. Furthermore, it may be concluded that an error and/or a problem has occurred. Such errors and/or problems may, e.g., comprise a non-ideal adjustment of the radio frequency cable trap circuit, defects of the radio frequency cable trap circuit, defects of the cable and/or a critical placing of the cable. These errors and/or problems may either be fixed or the radio frequency cable trap circuit and/or the cable may be replaced. Fixing may, e.g., comprise correcting the adjustment of the radio frequency cable trap circuit and/or correcting the placement of the cable.

Such errors and/or problems may even occur for an unconnected coil in a magnetic resonance imaging system. In case of an error and/or problem a cable and/or a radio frequency cable trap circuit represent a risk, e.g., a risk of skin burns due to an electromagnetic coupling resulting in an inducing of an alternating energy that is too large and/or may be suppressed insufficiently. Thus, the examples may increase patient safety for both, connected as well as unconnected coils.

A critical operation of a magnetic resonance imaging system may result in a high voltage induced across the radio frequency cable trap circuit, which may generate a high current within the radio frequency cable trap circuit.

The suppressed energy refers to the energy resulting from the suppression, i.e., an amount of residual energy remaining after the suppression.

For example, a power threshold indicative of the predefined upper threshold may be sensed using a power sensor circuit comprised by the radio frequency cable trap assembly, e.g., by the radio frequency cable trap circuit and/or the indication circuit. The power sensor circuit is, e.g., configured for sensing a power resulting from suppressed energy, i.e., an amount of suppressed energy induced in the radio frequency cable trap circuit per unit time. The power sensor circuit is, e.g., configured for sensing a power resulting from the transferred portion of the suppressed energy, i.e., an amount of suppressed energy being transferred per unit time from the radio frequency cable trap circuit to the indication circuit via the energy transfer coupling between the radio frequency cable trap circuit and the indication circuit.

For example, the predefined upper threshold as an energy threshold or another anergy threshold indicative of the predefined upper threshold maybe sensed using an energy sensor circuit comprised by the radio frequency cable trap assembly, e.g., by the radio frequency cable trap circuit and/or the indication circuit. The energy sensor circuit is, e.g., configured for sensing the suppressed energy induced in the radio frequency cable trap circuit. The energy sensor circuit is, e.g., configured for sensing the portion of the suppressed energy transferred from the radio frequency cable trap circuit to the indication circuit via the energy transfer coupling between the radio frequency cable trap circuit and the indication circuit.

For example, a current threshold indicative of the predefined upper threshold may be sensed using a current sensor circuit comprised by the radio frequency cable trap assembly, e.g., by the radio frequency cable trap circuit and/or the indication circuit. The current sensor circuit is, e.g., configured for sensing a current resulting from the suppressed energy induced in the radio frequency cable trap circuit. The current sensor circuit is, e.g., configured for sensing a current resulting from the portion of the suppressed energy transferred from the radio frequency cable trap circuit to the indication circuit via the energy transfer coupling between the radio frequency cable trap circuit and the indication circuit.

For example, a voltage threshold indicative of the predefined upper threshold may be sensed using a voltage sensor circuit comprised by the radio frequency cable trap assembly, e.g., by the radio frequency cable trap circuit and/or the indication circuit. The voltage sensor circuit is, e.g., configured for sensing a voltage resulting from the suppressed energy induced in the radio frequency cable trap circuit. The voltage sensor circuit is, e.g., configured for sensing a voltage resulting from the portion of the suppressed energy transferred from the radio frequency cable trap circuit to the indication circuit via the energy transfer coupling between the radio frequency cable trap circuit and the indication circuit.

For example, a temperature threshold indicative of the predefined upper threshold may be sensed using a temperature sensor circuit comprised by the radio frequency cable trap assembly, e.g., by the radio frequency cable trap circuit and/or the indication circuit. The temperature sensor circuit is, e.g., configured for sensing a temperature resulting from the suppressed energy induced in the radio frequency cable trap circuit. The temperature sensor circuit is, e.g., configured for sensing a temperature resulting from the portion of the suppressed energy transferred from the radio frequency cable trap circuit to the indication circuit via the energy transfer coupling between the radio frequency cable trap circuit and the indication circuit.

Embodiments may have the beneficial effect of enabling a detection of a critical trap heating of the radio frequency cable trap circuit and/or the cable for which the radio frequency cable trap assembly is used. Such a heating may result from the induced alternating energy. A reaching of a potential critical or at least an unwanted heating may be determined based on the reaching of the predefined upper threshold by the suppressed energy. This threshold may indicate an energy which is large enough to potentially cause an unwanted or even critical level of heating. The indication signal output upon the reaching of a predefined upper threshold by the suppressed energy may therefore indicate the unwanted or even critical level of heating. Thus, the outputting may enable a stopping of a magnetic resonance imaging scanning before a patient is harmed, e.g., burned, due to the heating. The magnetic resonance imaging scanning may, e.g., stop automatically upon reception of the indication signal by a reception unit of a magnetic resonance imaging system executing the magnetic resonance imaging scan. For example, a system-integrated body coil may be used, which is connected to a receive chain. The body coil may enable a sensing of a signal within or slightly outside the MR bandwidth without the need of additional hardware. The reception unit may forward the received indication signal to a control unit of the magnetic resonance imaging system, which may stop executing the magnetic resonance imaging scan. With the magnetic resonance imaging scan being stop, the inducing of the alternating energy at a predefined magnetic resonance imaging operation frequency in a cable may be stop. Thus, a further heating of the heating of the cable and/or the radio frequency cable trap circuit may be stop and the cable and/or the radio frequency cable trap circuit may cool down again. Alternatively, the magnetic resonance imaging scan may be stop by an operator operating the magnetic resonance imaging system upon reception of the output indication signal. The indication signal may, e.g., indicate a detected issue with the radio frequency cable trap circuit and/ or sensor values. The detected issue and/or any sensor values may, e.g., be transmitted to a cloud server and/or be written into logfiles for later use like service.

Upon a stopping of the magnetic resonance imaging scan, the cable and/or the radio frequency cable trap circuit may be check for potential errors, like a non-ideal adjustment of the radio frequency cable trap circuit, defects of the radio frequency cable trap circuit, defects of the cable and/or acritical placing of the cable. In case errors are encountered, they may, e.g., either be fixed or the radio frequency cable trap circuit and/or the cable may be replaced. Fixing may, e.g., comprise correcting the adjustment of the radio frequency cable trap circuit and/or correcting the placement of the cable.

Embodiments may have the beneficial effect that a heating of the cable and/or the radio frequency cable trap assembly up to a level, which may potentially be harmful for a patient, may be prevented. Thus, by stopping a magnetic resonance imaging scan, e.g., a patient being scanned may be protected against any danger, like burns, resulting from the heating of the cable and/or the radio frequency cable trap circuit. This may be particularly beneficial for protecting sedated patients, which are unable to report any problematic heating occurring during their sedation.

In another embodiment, the indication circuit comprises a passive switch controlled by the portion of the suppressed energy transferred via the energy transfer coupling and configured for activating an outputting mode of the indication circuit for outputting the indication signal upon the reaching of the predefined upper threshold by the suppressed energy. Embodiments may have the beneficial effect, that based on the portion of the suppressed energy transferred and thus on the suppressed energy being induced, activating an outputting mode of the indication circuit, e.g., the output unit of the indication circuit may be controlled. For example, the output unit may be in a sleep mode and only activated, when the suppressed energy reaches the predefined upper threshold.

In another embodiment, the indication circuit comprises a comparator configured for comparing a parameter descriptive of the portion of the suppressed energy transferred via the energy transfer coupling with a reference parameter descriptive of a reaching of the predefined upper threshold. The indication circuit is configured for activating the outputting mode upon determining using the comparator that the suppressed energy reaches the predefined upper threshold. Embodiments may have the beneficial effect, that based on the portion of the suppressed energy transferred and thus on the suppressed energy being induced, activating an outputting mode of the indication circuit, e.g., the output unit of the indication circuit may be controlled. For example, the output unit may be in a sleep mode and only activated, when the suppressed energy reaches the predefined upper threshold

In another embodiment, the energy transfer coupling is an inductive coupling.

An inductive coupling or magnetic coupling refers to a coupling such that a change in current through one wire induces a voltage across the ends of another wire through electromagnetic induction. A changing current through the first wire creates a changing magnetic field around it by Ampere's circuital law. The changing magnetic field induces an electromotive in the second wire by Faraday's law of induction.

For example, the radio frequency cable trap circuit may couple inductively via its local magnetic field to the indication circuit, which comprises a pickup loop for picking up an induced voltage. The radio frequency cable trap circuit may, e.g., suppress an alternating current at a predefined magnetic resonance imaging operation frequency, e.g., at 1.5T Larmor frequency, in a cable. For a high enough power absorbed within the radio frequency cable trap circuit, a voltage induced in the indication circuit may become large enough for enabling a non-negligible energy harvesting of the energy transferred from the radio frequency cable trap circuit by the indication circuit. The harvested energy may be large enough for powering the transmission of the indication signal by the indication circuit, e.g., to a magnetic resonance imaging system.

For example, an alternating voltage may be induced within the indication circuit by the energy transfer. The induced alternating voltage may be used for generating a DC voltage, e.g., by rectification. The resulting DC voltage may be used for powering an oscillator, e.g., a crystal oscillator, configured for transmitting a pilot tone as an indication signal. The pilot tone may, e.g., be transmitted within a receiver bandwidth of a receiver of a magnetic resonance imaging system. For example, the pilot tone may indicate a detection of a heating of the radio frequency cable trap circuit reaching the predefined upper threshold. The magnetic resonance imaging system may be configured to detect the pilot tone transmitted within the receiver bandwidth using its receiver. By detecting a reception of the pilot tone, the magnetic resonance imaging system may detect the heating of the radio frequency cable trap circuit reaching the predefined upper threshold.

Furthermore, the indication circuit may, e.g., comprise a microcontroller, which may be powered using the energy harvesting as well. This microcontroller may enable the indication circuit e.g., to collect and transmit additional data, like a temperature, a power level, etc. of the radio frequency cable trap circuit and/or the indication circuit.

In another embodiment, the energy transfer coupling is a capacitive coupling. A capacitive coupling refers to a transfer of energy within an electrical network by means of displacement current between circuits nodes, induced by an electric field. In its simplest implementation, capacitive coupling may be achieved by placing capacitors between nodes.

In another embodiment, the indication circuit comprises an energy harvesting circuit configured for harvesting the portion of the suppressed energy transferred via the energy transfer coupling. The indication circuit is configured for using the harvested energy for the outputting of the indication signal.

Embodiments may have the beneficial effect of integrating an energy harvesting functionality into the radio frequency cable trap assembly. This energy harvesting functionality may be used to supply the indication circuit with energy, enabling the indication circuit to output the indication signal using the output unit. Thus, the indication circuit may not require an independent energy supply, but may be provided with energy via the energy harvesting, whenever a portion of the suppressed energy is transferred from the radio frequency cable trap circuit to the portion indication circuit via the energy transfer coupling. Since the purpose of the indication circuit is the reaching of the predefined upper threshold by the suppressed energy, the indication circuit may require a power supply only in case of a non-negligible suppressed energy, i.e., of a non-negligible amount of energy being induced despite the suppression by the radio frequency cable trap circuit. Such a non-negligible suppressed energy may provide the indication circuit with energy via the energy harvesting. Thus, a power supply of the indication circuit in case of need may be ensured. The power supply of the indication circuit may thus be independent of any additional connection of the radio frequency cable trap assembly to an external power supply. It may also work in case a cable and/or a magnetic resonance imaging coil, which are provided with the radio frequency cable trap assembly, are not connected to a power supply.

A critical operation of a magnetic resonance imaging system may result in a high voltage induced across the radio frequency cable trap circuit, which may generate a high current within the radio frequency cable trap circuit. Such a high current may further result in a high radio frequency magnetic field being generated inside within the radio frequency cable trap circuit. This locally generated radio frequency magnetic field may be high enough to be used for energy harvesting by the indication circuit of the intelligent radio frequency cable trap assembly. The indication circuit may be configured for harvesting energy, e.g., using a voltage induced within the indication circuit by the radio frequency magnetic field generated by the radio frequency cable trap circuit. As soon as this voltage harvested by the indication circuit reaches a critical limit, i.e., the predefined upper threshold, which may be defined as a voltage threshold, the indication circuit may communicate with the magnetic resonance imaging system indicating the reaching of the predefined upper threshold and/or requesting a stop of a magnetic resonance imaging data acquisition by the magnetic resonance imaging system. In a further embodiment, additional information like temperature, current, forces, magnetic fields etc. may be sensed using suitable sensors comprised by the intelligent radio frequency cable trap assembly and sent to the magnetic resonance imaging system as well.

For example, the harvested energy may be employed by the indication circuit to power the on-board transmitter to transmit data concerning the status of the radio frequency trap circuit to a host system, e.g., a magnetic resonance imaging system.

The radio frequency cable trap circuit is intended to sufficiently suppress an inducing of an alternating energy in a cable. As long as no errors or other complications occur, energy induced in the cable by radio frequency radiation, in particular by pulses with predefined magnetic resonance imaging operation frequency, may effectively be suppressed by the radio frequency cable trap circuit. Thus, the predefined upper threshold of the suppressed energy may, e.g., only be reached in case of some error. Such errors may, e.g., comprise a non-ideal adjustment of the radio frequency cable trap circuit, defects or critical placing of cable, for which the radio frequency cable trap assembly is used. In such cases, it may still happen, that a large energy, e.g., strong currents, are induced in the cable and/or the radio frequency cable trap circuit. Such a large every being induced despite the suppression may, e.g., lead to a critical heating of the cable and/or the radio frequency cable trap circuit.

Such error scenarios, in which the indication circuit is needed, may also comprise errors regarding power supplies. For example, some components of a magnetic resonance imaging system in which the radio frequency cable trap circuit assembly is used, may not be connected with their power supply. For example, a cable and/or a magnetic resonance imaging coil using the radio frequency cable trap circuit assembly may be unconnected. Using energy harvesting for supplying the indication circuit with energy may have the beneficial effect of making the power supply of the indication circuit independent of errors relating connections to external power supplies. Such errors relating to external power supplies may, e.g., result from operating errors. For example, it may have simply been forgotten by an operator to plug in such an eternal power supply. An indication circuit powered using energy harvesting may be independent of such operating errors.

In another embodiment, the indication circuit comprises a battery unit configured for providing the energy for the outputting of the indication signal. Embodiments may have the beneficial effect that with the battery unit an autarkic power supply for the indication circuit is provided. Energy harvesting and battery unit may also be combined: in normal operation energy harvesting may, e.g., be configured to re-charge the battery unit, which may cost only a minor amount of energy over time, without impact, i.e., backlash, on the normal operation. Thus, it may be ensured that the battery unit remains charged in order to provide energy for the outputting of the indication signal in case of need. Upon reaching the predefined upper threshold by the suppressed energy, e.g., a passive switch may trigger the outputting of the indication signal driven from the charged battery unit.

In another embodiment, the indication signal comprises a visual signal. The output unit comprises a visual signal emitting circuit configured for emitting the visual signal.

In another embodiment, the indication signal comprises an acoustic signal. The output unit comprises an acoustic signal emitting circuit configured for emitting the acoustic signal.

In another embodiment, the indication signal comprises a wireless signal. The output unit comprises a wireless signal transmission circuit configured for transmitting the wireless signal.

In another embodiment, the indication circuit is configured for transmitting the wireless signal at a radio frequency band at least partially overlapping with, within or near a predefined magnetic resonance imaging operation frequency bandwidth comprising the predefined magnetic resonance imaging operation frequency.

For example, the radio frequency band is a frequency band comprised by a magnetic resonance imaging bandwidth. A receiver component, e.g., one or more receive coils, of a magnetic resonance imaging system, may be configured for receiving magnetic resonance signals, i.e., radio frequency signals, within the magnetic resonance imaging bandwidth. Transmitting the wireless signal at the magnetic resonance imaging bandwidth, i.e., at a radio frequency with the magnetic resonance imaging bandwidth, by the radio frequency cable trap assembly arranged within this magnetic resonance imaging system may have the beneficial effect that the magnetic resonance imaging receiver component is enabled to receive and process the wireless signal. The receiver component of the magnetic resonance imaging system may be highly sensitive for receiving radio frequency signals within the magnetic resonance imaging bandwidth.

A magnetic resonance imaging system may comprise a main magnet, which is configured for generating a main magnetic field for polarizing a sample, one or more shim coils for correcting shifts in the homogeneity of the main magnetic field, a gradient system used for localizing a region to be scanned and a radio frequency system configured for exciting the sample using radio frequency pulses and detecting magnetic resonance signals resulting from the excitation. The magnetic resonance signals in magnetic resonance imaging are generated by a process of resonance resulting from excitation by the radio frequency pulses. The radio frequency system may comprise transmitting components, i.e., one or more transmitter coils configured for generating the radio frequency pulses used to excite the sample. Atomic nuclei of interest for acquiring magnetic resonance imaging data have their own resonant frequencies, in the radiofrequency portion of the electromagnetic spectrum. In order to excite the atomic nuclei of interest the radio frequency pulses are send using these resonance frequencies as magnetic resonance imaging operation frequency. The radio frequency system may comprise receiver components, i.e., one or more receiver coils configured to receive the magnetic resonance signals within magnetic resonance imaging bandwidth. The receiver coils pick up the oscillations excited at radio frequencies produced by precession of the magnetic moment of the nuclei within the sample. Thus, the magnetic resonance signal acquired by the receiver coils is an induced electromagnetic field oscillating within the magnetic resonance imaging bandwidth.

For example, the indication circuit is configured for transmitting the wireless signal at a radio frequency band not comprising the predefined magnetic resonance imaging operation frequency.

In another embodiment, the indication circuit is configured for transmitting the wireless signal at a frequency band outside the predefined magnetic resonance imaging operation frequency bandwidth comprising the predefined magnetic resonance imaging operation frequency

For example, RFID technology may be used for transmitting the indication signal. The indication circuit may, e.g., comprise an RFID-chip. For example, a power picked up by the indication circuit from the radio frequency cable trap circuit may be high enough to trigger and/or power the RFID chip. The RFID chip may be configured to submit a unique ID assigned to the RFID-Chip and thus to the radio frequency cable trap assembly comprising the RFID-Chip. The unique ID may be encoded in a radio frequency signal transmitted as the indication signal by the RFID-Chip. The signal transmitted by the RFID-Chip may be transmitted at a radio frequency band apart from the magnetic resonance imaging bandwidth received by the receiver component of the magnetic resonance imaging system configured for receiving magnetic resonance signals for magnetic resonance imaging data acquisition. The signal transmitted by the RFID-Chip may be received by a dedicated radio frequency receiver. This dedicated radio frequency receiver may be comprised by the magnetic resonance imaging system. For example, the dedicated radio frequency receiver may be implemented in a patient table or a bore of the magnetic resonance imaging system. The unique ID comprised by the indication signal transmitted by the RFID-chip may enable the receiver, e.g., the magnetic resonance imaging system comprising a dedicated radio frequency receiver, to identify the radio frequency cable trap assembly causing the issuing of the respective indication signal, i.e., the origin of the indication signal. The receipt of the indication signal may e.g., cause the magnetic resonance imaging system or a computer system controlling the magnetic resonance imaging system to stop a magnetic resonance imaging scan executed by the magnetic resonance imaging system. Furthermore, e.g., a request may be output requesting an operator to reposition a cabling comprising the radio frequency cable trap assembly identified by the unique ID. In case, an incitation signal is received repeatedly for the same radio frequency cable trap assembly, a repair action may be triggered. For example, a repair request may be output requesting an operator to repair the identified radio frequency cable trap assembly and/or a cable comprising the identified radio frequency cable trap assembly. For example, a counter is used for counting a number of indication signals issued for the radio frequency cable trap assembly identified by the unique ID. The outputting of the repair request may be triggered upon a reaching of the predefined threshold by the counter.

In another embodiment, the indication circuit comprises one or more sensor circuits for acquiring sensor data and a microcontroller. The microcontroller is configured for controlling the acquiring of sensor data and a transmitting of the acquired sensor data via the wireless signal.

Using a microcontroller, the indication circuit may be enabled to e.g., collect and transmit additional sensor data acquired by the sensor circuits.

In another embodiment, the one or more sensor circuits are configured for acquiring sensor data of one or more of the following parameters: a temperature of the radio frequency cable trap assembly; a voltage in the radio frequency cable trap circuit resulting from the suppressed energy; a voltage in the indication circuit resulting from the transferred portion of the suppressed energy; a current in the radio frequency cable trap circuit resulting from the suppressed energy; a current in the indication circuit resulting from the transferred portion of the suppressed energy; a magnetic field strength; an environment temperature; an environment humidity.

For example, the indication circuit as a pick-up circuit may be configured that for the suppressed energy induced in the radio frequency cable trap circuit reaching the predefined upper threshold, the power picked up by the indication circuit is high enough to supply sufficient power for driving the microcontroller. The microcontroller may be configured for featuring a sensing, e.g., of an electromagnetic field, an environmental parameter, like temperature or humidity, or a movement. The microcontroller may further be configured to report the sensing results, e.g., to a remote router wirelessly, e.g., via WIFI, Bluetooth (LE) or any other power efficient wireless communication scheme. The submitted data may be used for controlling the magnetic resonance imaging system, and particularly for preventing hazardous situations for a patient as described above. Such a hazardous situation may, e.g., be prevented by an automatic stopping of a magnetic resonance imaging scanning operation executed by the magnetic resonance imaging system.

Temperature and/or power may for example be measured using a local bolometer, a thermistor or a sensor comprising a switch controlled by a heat-depending mechanical extension. A heat-depending mechanical extension may, e.g., be implemented using a bimetal component. A bimetal component comprises at least to layers of different metals with different heat extension coefficients. Due to the difference of the heat extension coefficients temperature changes are converted into mechanical displacements. The bimetal component may, e.g., have the form of a strip or disk.

The indication circuit may, e.g., comprise a voltage sensor configured for measuring a voltage over the radio frequency cable trap circuit. Furthermore, a comparator may be provided configured for comparing a voltage being sensed over the radio frequency cable trap circuit by the voltage sensor with a predefined voltage threshold. In case the sensed voltage reaches the predefined voltage threshold, the indication signal may be issued by the indication circuit, e.g., to prompt a scan controller of a magnetic resonance imaging system to stop a scanning executed by the magnetic resonance imaging system.

In another embodiment, the transmitted wireless signal comprises an ID of the radio frequency cable trap assembly identifying the radio frequency cable trap assembly transmitting the wireless signal.

The radio frequency cable trap assembly may be used to prevent and/or detect currents on any galvanic structure inside an MRI system. It may, e.g., be applied to a magnetic resonance imaging coil, in particular an MRI receive coil. For example, the radio frequency cable trap may be connected to or implemented into any kind of cable connected to a magnetic resonance imaging coil.

In another aspect, the invention provides for a cable for a magnetic resonance imaging coil comprising the radio frequency cable trap assembly of any of the aforementioned embodiments of the radio frequency cable trap assembly. The cable may, e.g., be a coaxial cable.

In another aspect, the invention provides for a magnetic resonance imaging coil with any of the aforementioned embodiments of a cable with a radio frequency cable trap assembly.

In another aspect, the invention provides for a magnetic resonance imaging system comprising the magnetic resonance imaging coil of any of the aforementioned embodiments of a magnetic resonance imaging coil. The magnetic resonance imaging coil is provided with a cable comprising a radio frequency cable trap assembly.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

### BRIEF DESCRIPTION OF THE DRAWINGS

In the following preferred embodiments of the invention will be described, by way of example only, and with reference to the drawings in which:
Fig. 1 illustrates an example of a radio frequency cable trap assembly;
Fig. 2 illustrates a further example of a radio frequency cable trap assembly;
Fig. 3 illustrates a further example of a radio frequency cable trap assembly;
Fig. 4 illustrates a further example of a radio frequency cable trap assembly;
Fig. 5 illustrates an example of a cable with a radio frequency cable trap assembly;
Fig. 6 illustrates an example of a coil connected with the exemplary cable of Fig. 5;
Fig. 7 illustrates an example of a magnetic resonance imaging system comprising the coil of Fig. 6;
Fig. 8 illustrates a further example of a radio frequency cable trap assembly with an inductive coupling;
Fig. 9 illustrates a functional behavior of the radio frequency cable trap assembly of Fig. 8;
Fig. 10 illustrates a further example of a radio frequency cable trap assembly with a capacitive coupling;
Fig. 11 illustrates a functional behavior of the radio frequency cable trap assembly of Fig. 10;
Fig. 12 illustrates an example of a radio frequency cable trap assembly with a battery unit;
Fig. 13 illustrates a further example of a radio frequency cable trap assembly with a battery unit;
Fig. 14 illustrates a further example of a magnetic resonance imaging system; and
Fig. 15 illustrates a further example of a magnetic resonance imaging system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

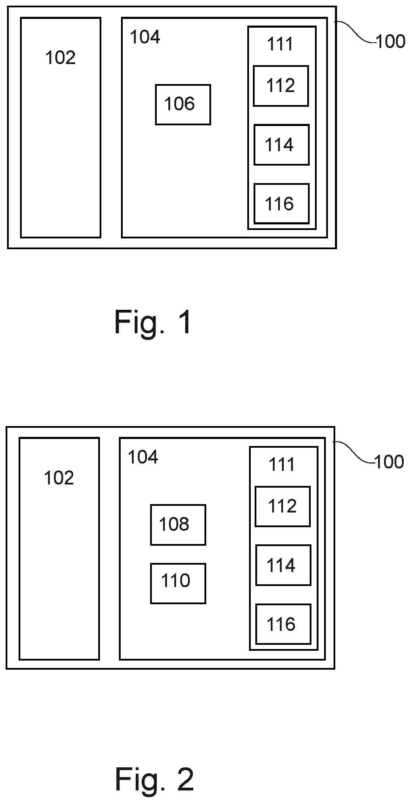

Fig. 1 illustrates an exemplary radio frequency cable trap assembly 100. The radio frequency cable trap assembly 100 comprises a radio frequency cable trap circuit 102 and an indication circuit 104. The radio frequency cable trap circuit 102 is configured for suppressing an inducing of an alternating energy at a predefined magnetic resonance imaging operation frequency in a cable. The cable may, e.g., be a cable of a magnetic resonance imaging coil of an MRI system. The indication circuit 104 comprises an output unit 111 configured for outputting an indication signal upon a reaching of a predefined upper threshold by the suppressed energy. For outputting the indication signal, the indication circuit 104 uses a portion of the suppressed energy transferred from the radio frequency cable trap circuit 102 to the indication circuit 104 via an energy transfer coupling between the radio frequency cable trap circuit 102 and the indication circuit 104. The coupling may, e.g., be an inductive or a capacitive coupling. The transferred portion of the suppressed energy may, e.g., be used for providing energy for operating the output unit 111 by an energy harvesting circuit 106 of the indication circuit. The energy harvesting circuit 106 is configured for harvesting the transferred portion of the suppressed energy for the outputting of the indication signal.

The indication signal may, e.g., be output in form of a visual signal, an acoustic signal and/or a wireless signal. For outputting the indication signal, the output unit 111 may, e.g., comprise one or more of the following a visual signal emitting circuit 112 configured for emitting the visual signal, an acoustic signal emitting circuit 114 configured for emitting the acoustic signal, a wireless signal transmission circuit 116 configured for transmitting the wireless signal. The visual signal emitting circuit 112 may, e.g., comprise one or more LEDs. The acoustic signal emitting circuit 114 may, e.g., comprise a buzzer or loudspeaker. The wireless signal transmission circuit 116 may, e.g., comprise a radio frequency transmitter. The radio frequency transmitter may, e.g., be configured to transmit the wireless signal in at a radio frequency band receivable by a receiver component of an MRI system configured for receiving MR radio frequency signals. The radio frequency transmitter may, e.g., be configured as an RFID-Chip. The RFID-Chip may be configured to transmit a radio frequency signal receivable by a dedicated receiver. The radio frequency transmitter may, e.g., be configured to transmit a WIFI signal or a Bluetooth (LE) signal receivable, e.g., by a remote router addressed by the transmitted signal.

Fig. 2 illustrates another exemplary radio frequency cable trap assembly 100. The radio frequency cable trap assembly 100 of Fig. 2 corresponds to the radio frequency cable trap assembly 100 of Fig. 1. The only difference is, that the radio frequency cable trap assembly 100 of Fig. 2 instead of an energy harvesting circuit comprises a battery unit 108 configured for providing the energy for the outputting of the indication signal by the output unit 111. According to an alternative implementation (not shown), the energy harvesting circuit 106 of the radio frequency cable trap assembly 100 of Fig. 1 may be combined with the battery unit 108 of the radio frequency cable trap assembly 100 of Fig. 2. In that case energy, e.g., for the outputting of the indication signal by the output unit 111, may be provided via energy harvesting using the energy harvesting circuit 106 as well as by the battery unit 108.

The output unit 111 may be in a sleep mode for saving energy. The transferred portion of the suppressed energy may control a passive switch 110. When the suppressed energy reaches the predefined upper threshold, the resulting transferred portion of the suppressed energy may be large enough to enable the passive switch and thereby activate the battery powered output unit 111. Thus, an outputting mode of the indication circuit 104 for outputting the indication signal using the battery powered output unit 111 may be activated. Upon the reaching of the predefined upper threshold by the suppressed energy in the radio frequency cable trap 102. A voltage above a predefined activation threshold fed to a trigger pin of the output unit 111 may wake up the unit and bring it to an active mode. In active mode, the output unit 111 may output the indication signal, with a significantly higher power consumption than in the sleep mode. For example, a comparator may be comprised by the indication circuit 104 configured for comparing a parameter descriptive of the portion of the transferred suppressed energy, e.g., a voltage, with a reference parameter, e.g., a reference voltage, descriptive of a reaching of the predefined upper threshold. The indication circuit 104 may be configured for activating the outputting mode of the output unit 111 upon determining using the comparator that the suppressed energy reaches the predefined upper threshold.

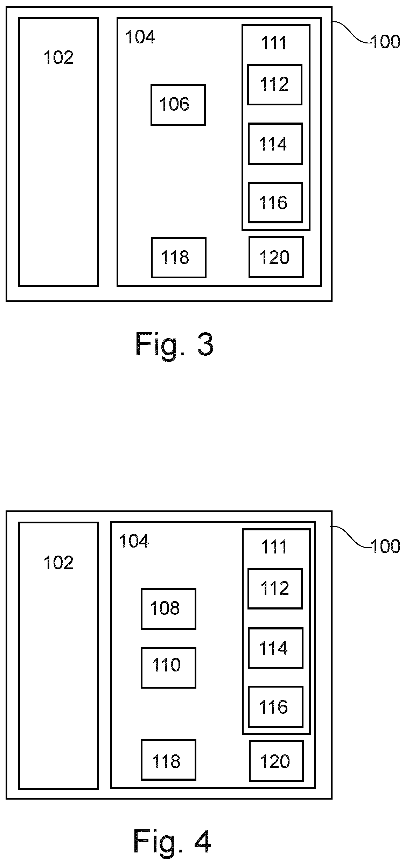

Fig. 3 illustrates another exemplary radio frequency cable trap assembly 100. The radio frequency cable trap assembly 100 of Fig. 3 corresponds to the radio frequency cable trap assembly 100 of Fig. 1. The radio frequency cable trap assembly 100 of Fig. 3 in addition comprises a microcontroller unit 118 and one or more sensor circuits 120 for acquiring sensor data. The microcontroller may, e.g., be configured for controlling the acquiring of the sensor data using the one or more sensor circuits 120 and for transmitting the acquired sensor data via the indication signal in form of a wireless signal using the wireless signal transmission circuit 116 of the output unit 111. The one or more sensor circuits 120 may, e.g., be configured for acquiring sensor data of one or more of the following parameters: a temperature of the radio frequency cable trap assembly, i.e., a temperature of the radio frequency cable trap circuit 102 and/or of the indication circuit 104; a voltage in the radio frequency cable trap circuit 102 resulting from the suppressed energy; a voltage in the indication circuit 104 resulting from the transferred portion of the suppressed energy; a current in the radio frequency cable trap circuit 102 resulting from the transferred portion of the suppressed energy; a current in the indication circuit 104 resulting from the transferred portion of the suppressed energy; a magnetic field strength; an environment temperature; an environment humidity.

Fig. 4 illustrates another exemplary radio frequency cable trap assembly 100. The radio frequency cable trap assembly 100 of Fig. 4 corresponds to the radio frequency cable trap assembly 100 of Fig. 2. The radio frequency cable trap assembly 100 of Fig. 4 in addition comprises a microcontroller unit 118 and one or more sensor circuits 120 for acquiring sensor data. The microcontroller may, e.g., be configured for controlling the acquiring of the sensor data using the one or more sensor circuits 120 and for transmitting the acquired sensor data via the indication signal in form of a wireless signal using the wireless signal transmission circuit 116 of the output unit 111. The one or more sensor circuits 120 may, e.g., be configured for acquiring sensor data of one or more of the following parameters: a temperature of the radio frequency cable trap assembly, i.e., a temperature of the radio frequency cable trap circuit 102 and/or of the indication circuit 104; a voltage in the radio frequency cable trap circuit 102 resulting from the suppressed energy; a voltage in the indication circuit 104 resulting from the transferred portion of the suppressed energy; a current in the radio frequency cable trap circuit 102 resulting from the transferred portion of the suppressed energy; a current in the indication circuit 104 resulting from the transferred portion of the suppressed energy; a magnetic field strength; an environment temperature; an environment humidity.

Fig: 5 illustrates an exemplary cable 200. The cable 200 comprises or is provided with a radio frequency cable trap assembly 100. The radio frequency cable trap assembly 100 may, e.g., be configured as any of the exemplary radio frequency cable trap assembly 100 illustrated in Fig. 1 to Fig. 4. The cable 200 may, e.g., be a cable for a magnetic resonance imaging coil to be used in an MRI system. For example, the cable 200 may be a coaxial cable. A connection to a receive coil may, e.g., comprise several coaxial cables as well as wires for power supply and (e.g., detune-) control lines. These components of the connection to the receive coil may, but do not have to have an external shield. For example, multiple traps may be placed along that cable depending on the frequency, i.e., distances significantly below half the free space wavelength.

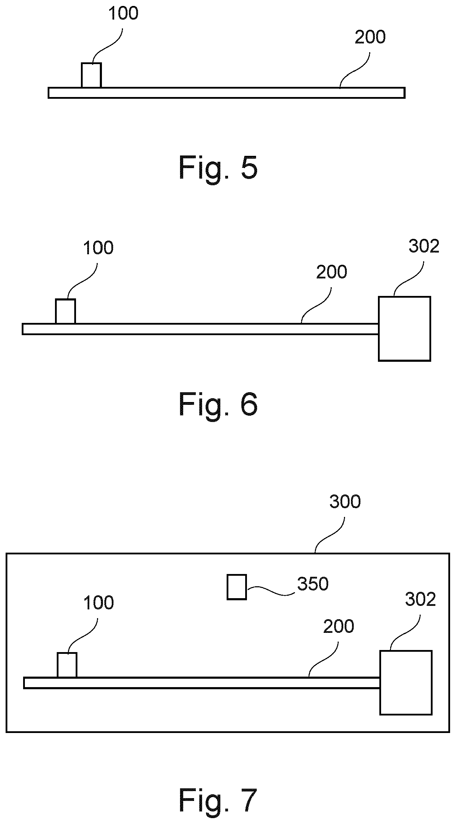

Fig. 6 illustrates an exemplary magnetic resonance imaging coil 302 provided with, i.e., connected to the cable 200 of Fig. 5 with a radio frequency cable trap assembly 100. The magnetic resonance imaging coil 302 may, e.g., be any receive coil of an MRI system, in particular a flexible placed surface receive coil.

Fig. 7 illustrates an exemplary magnetic resonance imaging system 300, which comprises the magnetic resonance imaging coil 302 of Fig. 6 connected to the cable 200 with the radio frequency cable trap assembly 100. The magnetic resonance imaging system 300 may further comprise a receiver component 350 configured for receiving an indication signal transmitted by an output unit of an indication circuit of the radio frequency cable trap assembly 100. The receiver component 350 may, e.g., a receive radio frequency coil of the magnetic resonance imaging system 300 configured for receiving MR signals within the MR bandwidth. The receiver component 350 may, e.g., be a dedicated receiver configured for receiving the indication signal transmitted in form of an RFID signal. The receiver component 350 may, e.g., be a remote router configured for receiving the indication signal transmitted in form of a wireless signal, e.g., a via WIFI, Bluetooth (LE) or any other power efficient wireless communication scheme. The remote router may, e.g., be configured to forward the indication signal to a controller of the magnetic resonance imaging system 300 or a remote server. For example, the remote server may forward the indication signal to the controller of the magnetic resonance imaging system 300.

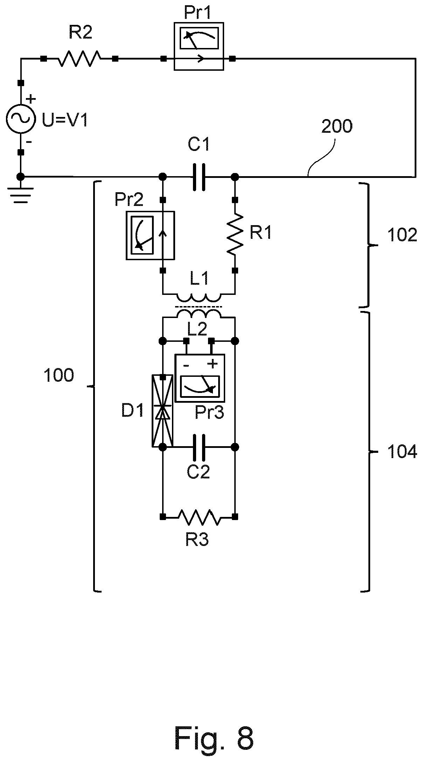

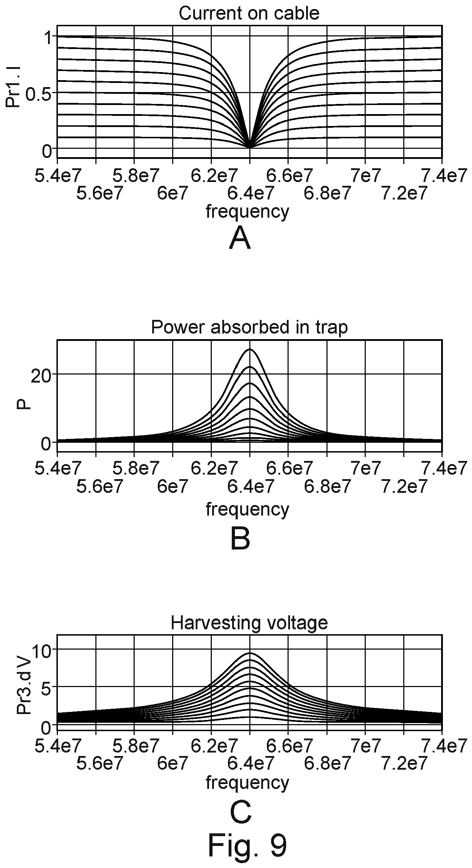

Fig. 8 illustrates an exemplary radio frequency cable trap assembly 100 for a cable 200 comprising a radio frequency cable trap circuit 102 and an indication circuit 104. The cable is represented by the lower part including the path through L1 forming a coil inductor which is connected in parallel to C1. The voltage feeding is illustrating an excitation via a transmit coil in an MRI system. The radio frequency cable trap circuit 102 comprises an inductance L1, e.g., in form of a loop, a capacitor C1 and a resistance R1, which couples inductively via a local magnetic field to a pickup loop L2 of the indication circuit 104. In the example of Fig. 8, the following values have been used for illustrative purposes: R1 = 0.1 S2, R2 = 1 kQ, R3 = 50 Q, C1 = 61.85 pF, C2 = 100 nF, L1 = 100 nH, L2 = 100 nH, k=0.01 (coupling between L1 and L2). Graph A of Fig. 9 illustrates a suppression of an alternating current on the cable 200 measured by Pr1 at a frequency of 64 MHz, i.e., at 1.5T Larmor frequency. The frequency varied from 54 MHz to 74 MHz. Graph B of Fig. 9 shows the power P = 0.5*R1*Pr2.I^2 absorbed in the radio frequency cable trap circuit 102. Pr2.I is the alternating current measured by Pr2. A parameter sweep for different B1 amplitudes, i.e., different parameters for V 1, is shown. For a high absorbed power P, a voltage at the harvesting coil L2, which is shown in graph C of Fig. 9 plotting the harvesting voltage Pr3.dV measured by Pr3, becomes large enough for energy harvesting and powering a unit to transmit data, e.g., to an MRI system.

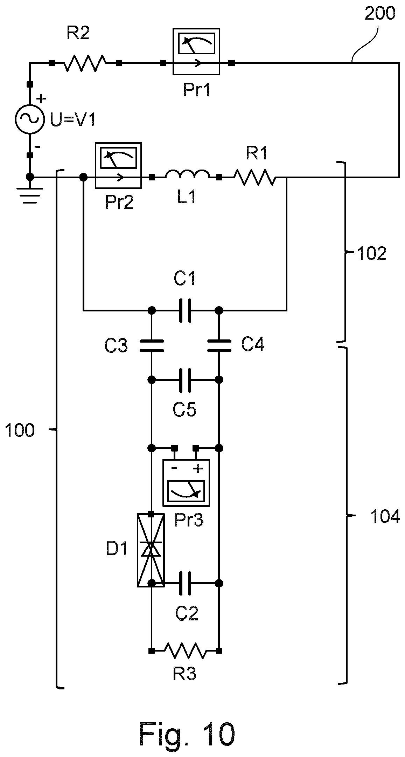

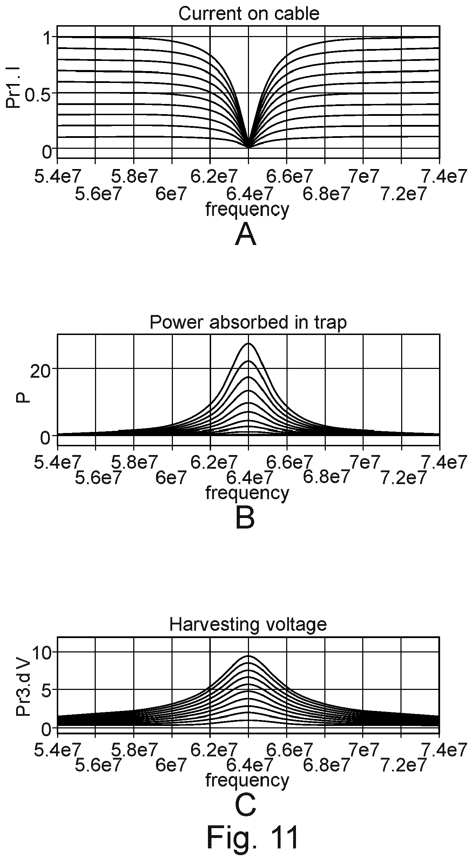

Fig. 10 illustrates an exemplary radio frequency cable trap assembly 100 for a cable 200 comprising a radio frequency cable trap circuit 102 and an indication circuit 104. The voltage feeding is illustrating an excitation via a transmit coil in an MRI system. In contrast to the inductive coupling between the radio frequency cable trap circuit 102 and the indication circuit 104 of radio frequency cable trap assembly 100 of Fig. 8, the radio frequency cable trap circuit 102 and the indication circuit 104 of radio frequency cable trap assembly 100 of Fig. 10 are coupled inductively via capacitors C3 and C4. The capacitive coupling may, e.g., implemented by lumped capacitors or by placing the lower capacitor C5 close to the upper capacitor C1 of the radio frequency cable trap circuit 102. Here, capacitor C1 was slightly reduced, since the capacitive coupling slightly detunes the resonance. In the example of Fig. 10, the following values have been used for illustrative purposes: R1 = 0.1 S2, R2 = 1 kQ, R3 = 50 Q, C1 = 61.3 pF, C2 = 100 nF, C3 = 1 pF, C4 = 1 pF, C5 = 50 pF, L1 = 100 nH. Graph A of Fig. 11 illustrates a suppression of an alternating current on the cable 200 measured by Pr1 at a frequency of 64 MHz, i.e., a 1.5T Larmor frequency. The frequency varied from 54 MHz to 74 MHz. Graph B of Fig. 11 shows the power P = 0.5*R1*Pr2.I^2 absorbed in the radio frequency cable trap circuit 102. Pr2.I is the alternating current measured by Pr2. A parameter sweep for different B1 amplitudes, i.e., different parameters for V1, is shown. For a high absorbed power P, a voltage at the harvesting coil L2, which is shown in graph C of Fig. 11 plotting the harvesting voltage Pr3.dV measured by Pr3, becomes large enough for energy harvesting and powering a unit to transmit data, e.g., to an MRI system.

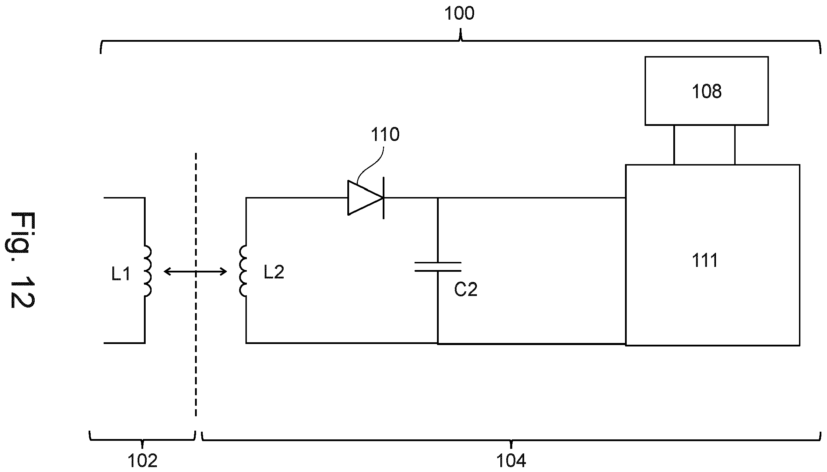

Fig. 12 illustrates an exemplary radio frequency cable trap assembly 100 with a battery unit 108. The radio frequency cable trap assembly 100 comprises a radio frequency cable trap circuit 102 and an indication circuit 104. The radio frequency cable trap assembly 100 is configured to transfer energy from the radio frequency cable trap circuit 102 to the indication circuit 104 via an inductive energy transfer coupling. The indication circuit 104 comprises a passive switch 110 controlled by the portion of the suppressed energy transferred via the inductive energy transfer coupling from the radio frequency cable trap circuit 102 to the indication circuit 104. When the transferred energy is large enough to enable the passive switch 110, the switch 110 activates an outputting mode of the indication circuit 104 for outputting an indication signal using the output unit 111. For example, the transferred energy may be large enough for enabling the passive switch, when it reaches the predefined upper threshold. The output unit 111 may be powered by the battery unit 108. For example, the output unit 111, which may comprise a microcontroller unit, is in a sleep mode with a low power consumption, enabling the output unit 111 to remain passive over a long time, e.g., over years. A voltage resulting from the transferred energy above a predefined wake-up threshold fed to a trigger pin may wake up the output unit 111 and bring it to an active mode, i.e., the outputting mode. Being brought into the output mode, the output unit 111 may output the indication signal consuming power provided by the battery unit 108. For example, energy harvesting and battery powered operation may also be combined: in normal operation energy harvesting may be configured to re-charge the battery unit, which may cost only a minor amount of energy over time, without impact, i.e., backlash, on the normal operation; then upon reaching the threshold, the switch 110 may trigger the required actions driven from the charged battery unit.

The indication signal may, e.g., be output by the battery powered output unit 111 in form of a visual signal, an acoustic signal and/or a wireless signal. For outputting the indication signal, the output unit 111 may, e.g., comprise one or more of the following a visual signal emitting circuit configured for emitting the visual signal, an acoustic signal emitting circuit configured for emitting the acoustic signal, a wireless signal transmission circuit configured for transmitting the wireless signal. The visual signal emitting circuit may, e.g., comprise one or more LEDs. The acoustic signal emitting circuit may, e.g., comprise a buzzer or loudspeaker. The wireless signal transmission circuit may, e.g., comprise a radio frequency transmitter. The radio frequency transmitter may, e.g., be configured to transmit the wireless signal in a radio frequency band receivable by a receiver component of an MRI system configured for receiving MR radio frequency signals. The radio frequency transmitter may, e.g., be a crystal oscillator. The radio frequency transmitter may, e.g., be configured as an RFID-Chip. The RFID-Chip may be configured to transmit a radio frequency signal receivable by a dedicated receiver. The radio frequency transmitter may, e.g., be configured to transmit a WIFI signal or a Bluetooth (LE) signal receivable, e.g., by a remote router addressed by the transmitted signal.

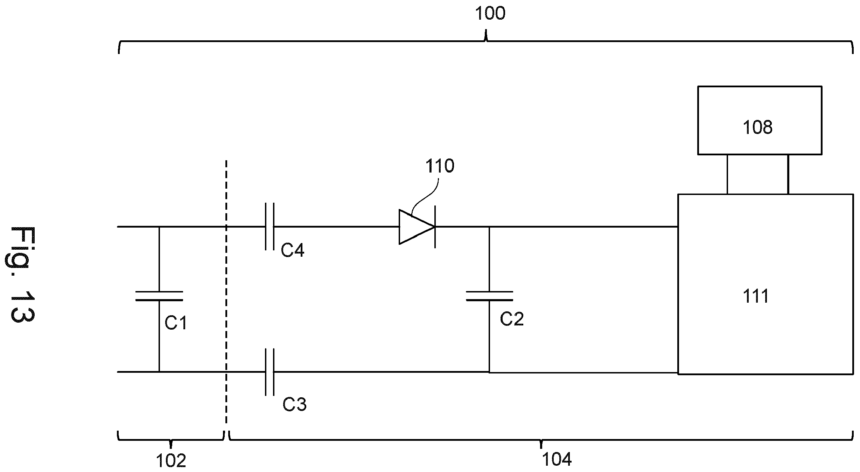

Fig. 13 illustrates another exemplary radio frequency cable trap assembly 100 with a battery unit 108. The radio frequency cable trap assembly 100 comprises a radio frequency cable trap circuit 102 and an indication circuit 104. The radio frequency cable trap assembly 100 is configured to transfer energy from the radio frequency cable trap circuit 102 to the indication circuit 104 via a capacitive energy transfer coupling. The indication circuit 104 comprises a passive switch 110 controlled by the portion of the suppressed energy transferred via the capacitive energy transfer coupling from the radio frequency cable trap circuit 102 to the indication circuit 104. When the transferred energy is lager enough to enable the passive switch 110, the switch 110 activates an outputting mode of the indication circuit 104 for outputting an indication signal using the output unit 111. For example, the transferred energy may be lager enough for enabling the passive switch, when it reaches the predefined upper threshold. The output unit 111 may be powered by the battery unit 108. For example, the output unit 111, which may comprise a microcontroller unit, is in a sleep mode with a low power consumption, enabling the output unit 111 to remain passive over a long time, e.g., over years. A voltage resulting from the transferred energy above a predefined wake-up threshold fed to a trigger pin may wake up the output unit 111 and bring it to an active mode, i.e., the outputting mode. Being brought into the output mode, the output unit 111 may output the indication signal consuming power provided by the battery unit 108.

The indication signal may, e.g., be output by the battery powered output unit 111 in form of a visual signal, an acoustic signal and/or a wireless signal. For outputting the indication signal, the output unit 111 may, e.g., comprise one or more of the following a visual signal emitting circuit configured for emitting the visual signal, an acoustic signal emitting circuit configured for emitting the acoustic signal, a wireless signal transmission circuit configured for transmitting the wireless signal. The visual signal emitting circuit may, e.g., comprise one or more LEDs. The acoustic signal emitting circuit may, e.g., comprise a buzzer or loudspeaker. The wireless signal transmission circuit may, e.g., comprise a radio frequency transmitter. The radio frequency transmitter may, e.g., be configured to transmit the wireless signal in at a radio frequency band receivable by a receiver component of an MRI system configured for receiving MR radio frequency signals. The radio frequency transmitter may, e.g., be configured as an RFID-Chip. The RFID-Chip may be configured to transmit a radio frequency signal receivable by a dedicated receiver. The radio frequency transmitter may, e.g., be configured to transmit a WIFI signal or a Bluetooth (LE) signal receivable, e.g., by a remote router addressed by the transmitted signal.

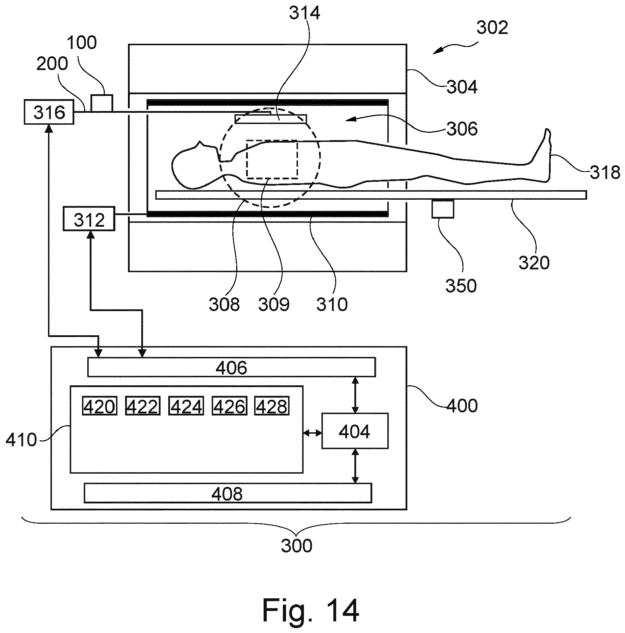

Fig. 14 illustrates an example of a magnetic resonance imaging system 300, that is controlled by a computer 400. The magnetic resonance imaging system 300 comprises a magnet 304. The magnet 304 is a superconducting cylindrical type magnet with a bore 306 through it. The use of different types of magnets is also possible; for instance, it is also possible to use both a split cylindrical magnet and a so-called open magnet.

Within the bore 306 of the cylindrical magnet 304 there is an imaging zone 308 where the magnetic field is strong and uniform enough to perform magnetic resonance imaging. A region of interest 309 is shown within the imaging zone 308. The magnetic resonance data that is acquired is typically acquired for the region of interest 309. A subject 318 is shown as being supported by a subject support 320 such that at least a portion of the subject 318 is within the imaging zone 308 and the region of interest 309.

Within the bore 306 of the magnet there is also a set of magnetic field gradient coils 310 which is used for acquisition of preliminary magnetic resonance data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. The magnetic field gradient power supply 312 supplies current to the magnetic field gradient coils 310. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency coil 314 may contain multiple coil elements. The radio frequency coil 314 may also be referred to as antenna. The radio frequency coil 314 is connected to a radio frequency transceiver 316, e.g., via a cable 200. The cable 200 may, e.g., comprise a radio frequency cable trap assembly 100 with a radio frequency cable trap circuit and an indication circuit. The radio frequency coil 314 and radio frequency transceiver 316 may, e.g., be replaced by separate transmit coils and receive coils and a separate transmitter and receiver. Alternatively, one or more receiver coils, which are connected to a radio frequency receiver, e.g., via a cable, may be comprised by the magnetic resonance imaging system 300 in addition to the depicted radio frequency coil 314 and transceiver 316. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receivers. The radio frequency coil 314 may also have multiple receive/transmit elements and the radio frequency transceiver 316 may have multiple receive/transmit channels. For example, if a parallel imaging technique such as SENSE is performed, the radio frequency could 314 will have multiple coil elements.

An indication signal output by the radio frequency cable trap assembly may, e.g., be output as a wireless signal at a radio frequency within an MR bandwidth, which is received by the radio frequency coil 314, e.g., a separate receive coil, of the magnetic resonance imaging system 300. For example, the magnetic resonance imaging system 300 may comprise a dedicated receiver 350 configured for receiving the indication signal transmitted in form of an RFID signal. The dedicated receiver 350 may e.g., be arranged at the subject support 320, within the bore 306, or also elsewhere inside the RF-shielded room. For example, a receiver may be provided in form of a remote router configured for receiving the indication signal transmitted in form of a wireless signal, e.g., a via WIFI, Bluetooth (LE) or any other power efficient wireless communication scheme. The remote router may, e.g., be configured to forward the indication signal to the computer 400 controlling the magnetic resonance imaging system 300 or a remote server. For example, the remote server may forward the indication signal to the computer 400 of the magnetic resonance imaging system 300.

The transceiver 316 and the gradient controller 312 are shown as being connected to the hardware interface 406 of the computer 400.

The computer 400 is intended to represent one or more computational or computing devices. The computer 400 is configured for acquiring medical imaging data as part of a control system of the magnetic resonance imaging system 300. The computer 400 is shown as comprising a computation system 404. The computational system 404 is intended to represent one or more processors or processing cores or other computational systems that are located at one or more locations. The computational system 404 is shown as being connected to an optional hardware interface 406, a user interface 408 and a memory 410. If other components are present the hardware interface 406 may enable the computational system 404 to exchange commands and data with those other components.

The optional hardware interface 406 may for example enable the computational system 404 to control other components such as a magnetic resonance imaging system 300. The computational system 404 is further shown as being connected to an optional user interface 408 which may for example enable an operator to control and operate the computer 400 and via the computer 400 the magnetic resonance imaging system 300. The optional user interface 408 may, e.g., comprise an output and/or input device enabling a user to interact with the computer 400. The output device may, e.g., comprise a display device configured for displaying magnetic resonance images and/or indication data 428 comprised by an indication signal received from an output unit of a radio frequency cable trap assembly 100. The input device may, e.g., comprise a keyboard and/or a mouse enabling the user to insert control commands for controlling the computer 400 and via the computer 400 the magnetic resonance imaging system 300. The computational system 404 is further shown as being connected to a memory 410. The memory 410 is intended to represent different types of memory which could be connected to the computational system 404 and may for example be a non-transitory storage medium.

The memory is shown as containing machine-executable instructions 420. The machine-executable instructions 420 enable the computational system 404 to perform tasks such as controlling other components to perform numerical tasks, as well as performing various data and image processing tasks. The machine-executable instructions 420 may, e.g., enable the computational system 404 to control the magnetic resonance imaging system 300. For example, the machine-executable instructions 420 may be configured for stopping an MRI scan executed by the magnetic resonance imaging system 300 in response to receiving an indication signal 428 from an output unit of the radio frequency cable trap assembly 100.

The memory 410 is further shown as containing pulse sequence commands 422. The pulse sequence commands 422 are commands or data which may be converted into such commands that are configured for controlling the magnetic resonance imaging system 300 to acquire the magnetic resonance imaging data 424 from the region of interest 309. The acquired magnetic resonance imaging data 424 is used to reconstruct magnetic resonance images 426.

The memory 410 is further shown as containing indication data 428 provided by the received indication signal and indicating a reaching of the upper predefined threshold by the suppress energy within the radio frequency cable trap assembly 100. The indication data 428 may be processed and/or stored by the computer 400. The indication signal may be received form an output unit of the radio frequency cable trap assembly 100. Upon the reception of the indication signal, the indication data 428 conveyed by the indication signal may be processed by the computational system 404, which may, e.g., automatically stop an MRI scan executed by the magnetic resonance imaging system 300 upon receive of the indication data 428. Indication data 428 provided by the received indication signal may, e.g., comprise additional information, like sensor data acquired by sensors of the radio frequency cable trap assembly 100.

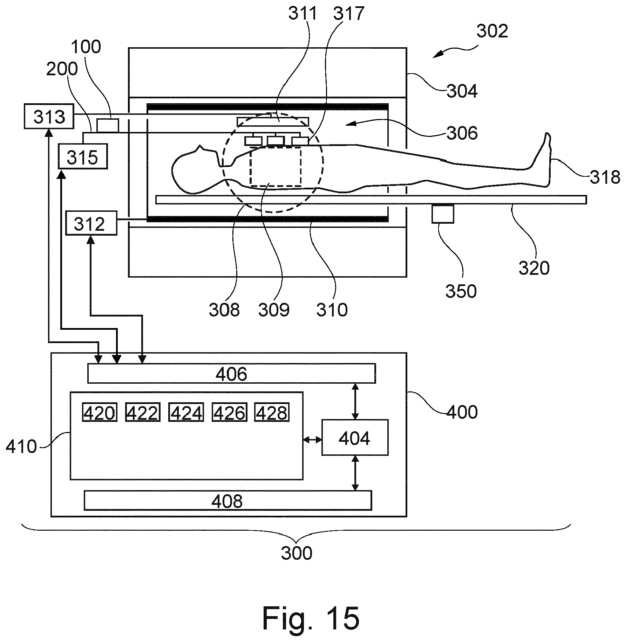

Fig. 15 illustrates another example of a magnetic resonance imaging system 300. The magnetic resonance imaging system 300 of Fig. 15 corresponds to the magnetic resonance imaging system 300 of Fig 14., wherein the radio frequency coil and the transceiver have been replaced by a separate transmit coil 311 and receive coils 317 and a separate transmitter 313 and receiver 317. The array of receive coils 317 is connected to the receiver 315, e.g., via a cable 200. The cable 200 may, e.g., comprise one ore multiple radio frequency cable traps assembly 100 with a radio frequency cable trap circuit and an indication circuit. Such traps 100 may be in particular beneficial at locations picking up B1 fields from the transmit coil 311, i.e., inside the bore 306. A first trap may, e.g., be arranged even within the receive coil 317. The coils 317 may, e.g., be configured for a locally flexible placement. For example, the receive coils 317 may be placed near or directly on the subject 318. Like the receive coils 317, the transmit coil 311 may contain multiple coil elements and, e.g., be implemented in form of an array of coils. The receiver 315 and transmitter 313 are shown as being connected to the hardware interface 406 of the computer 400.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: radio frequency cable trap assembly
- 102: radio frequency cable trap circuit
- 104: indication circuit
- 106: energy harvesting circuit
- 108: battery unit
- 110: switch
- 111: output unit
- 112: visual signal emitting circuit
- 114: acoustic signal emitting circuit
- 116: wireless signal transmission circuit
- 118: microcontroller unit
- 120: sensor circuits
- 200: cable
- 300: magnetic resonance imaging system
- 302: coil
- 304: magnet
- 306: bore of magnet
- 308: imaging zone
- 309: region of interest
- 310: magnetic field gradient coils
- 311: radio-frequency transmit coil
- 312: magnetic field gradient coil power supply
- 313: transmitter
- 314: radio-frequency coil
- 315: receiver
- 316: transceiver
- 317: radio-frequency receive coil
- 318: subject
- 320: subject support
- 350: receiver component
- 400: computer
- 404: computational system
- 406: optional hardware interface
- 408: optional user interface
- 410: memory
- 420: machine executable instructions
- 422: pulse sequence commands
- 424: magnetic resonance imaging data
- 426: magnetic resonance images
- 428: indication data

## Claims

1. A radio frequency cable trap assembly (100) comprising:
- a radio frequency cable trap circuit (102), the radio frequency cable trap being configured for suppressing an inducing of an alternating energy at a predefined magnetic resonance imaging operation frequency in a cable (200) for a magnetic resonance imaging coil (302, 310, 314); and
- an indication circuit (104) comprising an output unit (111) configured for outputting an indication signal upon a reaching of a predefined upper threshold by the suppressed energy using a portion of the suppressed energy transferred from the radio frequency cable trap circuit (102) to the indication circuit (104) via an energy transfer coupling between the radio frequency cable trap circuit (102) and the indication circuit (104).

2. The radio frequency cable trap assembly (100) of claim 1, the indication circuit (104) comprising a passive switch (110) controlled by the portion of the suppressed energy transferred via the energy transfer coupling and configured for activating an outputting mode of the indication circuit (104) for outputting the indication signal upon the reaching of the predefined upper threshold by the suppressed energy or
the indication circuit (104) comprising a comparator configured for comparing a parameter descriptive of the portion of the suppressed energy transferred via the energy transfer coupling with a reference parameter descriptive of a reaching of the predefined upper threshold, the indication circuit (104) being configured for activating the outputting mode upon determining using the comparator that the suppressed energy reaches the predefined upper threshold.

3. The radio frequency cable trap assembly (100) of any of the preceding claims, the energy transfer coupling being an inductive coupling or
the energy transfer coupling being a capacitive coupling.

4. The radio frequency cable trap assembly (100) of any of the preceding claims, the indication circuit (104) comprising an energy harvesting circuit (106) configured for harvesting the portion of the suppressed energy transferred via the energy transfer coupling, the indication circuit (104) being configured for using the harvested energy for the outputting of the indication signal.

5. The radio frequency cable trap assembly (100) of any of the preceding claims, the indication circuit (104) comprising a battery unit (108) configured for providing the energy for the outputting of the indication signal.

6. The radio frequency cable trap assembly (100) of any of the preceding claims, the indication signal comprising a visual signal and the output unit (111) comprising a visual signal emitting circuit (112) configured for emitting the visual signal.

7. The radio frequency cable trap assembly (100) of any of the preceding claims, the indication signal comprising an acoustic signal and the output unit (111) comprising an acoustic signal emitting circuit (114) configured for emitting the acoustic signal.

8. The radio frequency cable trap assembly (100) of any of the preceding claims, the indication signal comprising a wireless signal and the output unit (111) comprising a wireless signal transmission circuit (116) configured for transmitting the wireless signal.

9. The radio frequency cable trap assembly (100) of claim 8, the indication circuit (104) being configured for transmitting the wireless signal at a radio frequency band at least partially overlapping a predefined magnetic resonance imaging operation frequency band comprising the predefined magnetic resonance imaging operation frequency, or
the indication circuit (104) being configured for transmitting the wireless signal at a radio frequency band outside the predefined magnetic resonance imaging operation frequency band.

10. The radio frequency cable trap assembly (100) of any of claims 8 to 9, the indication circuit (104) comprising one or more sensor circuits (120) for acquiring sensor data and a microcontroller (118) for controlling the acquiring of sensor data and a transmitting of the acquired sensor data via the wireless signal.

11. The radio frequency cable trap assembly (100) of claim 10, the one or more sensor circuits being configured for acquiring sensor data of one or more of the following parameters:
- a temperature of the radio frequency cable trap assembly (100);
- a voltage in the radio frequency cable trap circuit (102) resulting from the suppressed energy;
- a voltage in the indication circuit (104) resulting from the transferred portion of the suppressed energy;
- a current in the radio frequency cable trap circuit (102) resulting from the suppressed energy;
- a current in the indication circuit (104) resulting from the transferred portion of the suppressed energy;
- a magnetic field strength;
- an environment temperature;
- an environment humidity.

12. The radio frequency cable trap assembly (100) of any of claims 8 to 11, the transmitted wireless signal comprising an ID of the radio frequency cable trap assembly (100) identifying the radio frequency cable trap assembly (100) transmitting the wireless signal.

13. A cable (200) for a magnetic resonance imaging coil (302, 310, 314) comprising the radio frequency cable trap assembly (100) of any of the preceding claims.

14. A magnetic resonance imaging coil (302, 310, 314) with the cable (200) of claim 13.

15. A magnetic resonance imaging system (300) comprising the magnetic resonance imaging coil (302, 310, 314) of claim 14.
